(19) Europäisches Patentamt
European Patent Office
Office européen des brevets

(11) **EP 2 325 955 A1**

(12) **EUROPEAN PATENT APPLICATION**

(43) Date of publication:
**25.05.2011 Bulletin 2011/21**

(51) Int Cl.:
*H01S 3/08* (2006.01)  *H01S 3/094* (2006.01)
*H01S 5/04* (2006.01)  *H01S 5/0687* (2006.01)
*H01S 5/14* (2006.01)  *H01S 5/183* (2006.01)
*H01S 3/13* (2006.01)

(21) Application number: **09014575.6**

(22) Date of filing: **23.11.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **Klastech- Karpushko Laser Technologies GmbH**
**44263 Dortmund (DE)**

(72) Inventor: **Karpushko, Fedor V., Prof. Dr.**
**44269 Dortmund (DE)**

(74) Representative: **Grünecker, Kinkeldey, Stockmair & Schwanhäusser**
**Anwaltssozietät**
**Leopoldstrasse 4**
**80802 München (DE)**

(54) **Resonant cavity optically pumped laser and method of operating the same**

(57)    An optically pumped laser comprises an active medium, a first optical cavity, a pump radiation source, a second optical cavity, and a tuning means. The active medium has a pump absorption band comprising a pump wavelength range and a laser transition at a laser wavelength. The first optical cavity comprises a first and a second laser radiation reflecting element. The first and the second laser radiation reflecting elements are adapted for reflecting electromagnetic radiation having the laser wavelength. The active medium is provided in the first optical cavity. The pump radiation source is adapted for emitting a pump radiation beam comprising electromagnetic radiation having a wavelength in the pump wavelength range. The second optical cavity comprises a first and a second pump radiation reflecting element adapted for reflecting electromagnetic radiation having a wavelength in the pump wavelength range. The first pump radiation reflecting element is a partially reflective element. The active medium is provided in the second optical cavity. The second optical cavity is arranged for receiving the pump radiation beam through the first pump radiation reflecting element. A first portion of the pump radiation beam is reflected from the first pump radiation reflecting element to form a first reflected beam. One or more second portions of the pump radiation beam are transmitted through the first pump radiation reflecting element after passage through the active medium and one or more reflections at the second pump radiation reflecting element. The one or more second portions of the pump radiation beam form a second reflected beam. The tuning means is adapted for tuning the optical path between the first and the second pump radiation reflecting elements and/or the wavelength of the pump radiation beam such that the second optical cavity is kept in res-

onance with the pump radiation wavelength, hence providing for minimization of the intensity of the pump radiation lost through reflection from the second optical cavity.

FIG. 2a

FIG. 2b

**Description**

The present invention relates to lasers, in particular to an optically pumped laser comprising an active medium, an optical cavity and a pump radiation source.

Optically pumped disk lasers wherein a disk-shaped active medium is employed can have several advantages, which include that they allow a more efficient cooling of the active medium compared to solid state lasers wherein the active medium is provided in form of an elongated rod. Moreover, due to the relatively small thickness of the active medium in the longitudinal direction of the optical cavity of the laser, adverse effects of thermal lensing that can be caused by an uneven heating of the active medium by the pump radiation can be avoided or at least reduced.

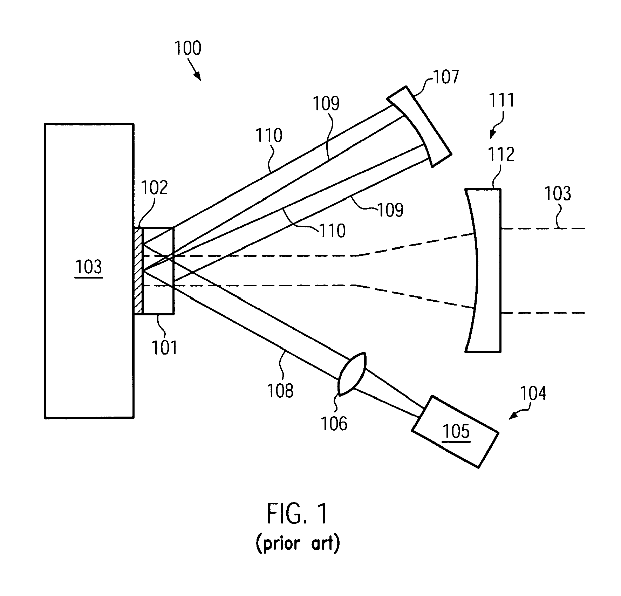

In the following, an optically pumped disk laser 100 according to the state of the art will be described with reference to Fig. 1.

The laser 100 comprises an active medium 101, that can, for example, be a disk formed of a known laser material such as, for example, Yb:YAG.

The active medium has a pump absorption band in a pump wavelength range, and a laser transition at a laser wavelength. If the laser is irradiated with electromagnetic radiation in the pump wavelength range, electrons can be excited from a ground state into an excited state from which they may then decay into the laser transition upper state. This process is denoted as "optical pumping".

If a stimulation by a first photon having the laser wavelength occurs, an electron from the laser transition upper state can make a transition to the laser transition termination state; that can be the ground state (in case of a three-level laser), or a higher energy state (in case of a four-level laser) via the process of stimulated emission. In this process, a second photon having the laser wavelength is emitted.

If a population inversion exists between the laser transition upper state and the termination state into which the electron undergoes a transition via the process of stimulated emission, an amplification of electromagnetic radiation can occur. The population inversion can be created by irradiating the active medium with electromagnetic radiation having a wavelength in the pump wavelength range to excite electrons into the laser transition upper state.

The laser 100 further comprises an optical cavity 111 that comprises an output coupler mirror 112 and a reflective coating 102 formed on a side of the active medium 101 opposite the output coupler mirror 112. The reflective coating 102 and the output coupler mirror 112 are adapted to reflect electromagnetic radiation having the laser wavelength, wherein the reflective coating 102 can be adapted to substantially reflect all electromagnetic radiation having the laser wavelength, and the output coupler 112 is partially transmissive for electromagnetic radiation having the laser wavelength.

Additionally, the laser 100 comprises a pump radiation source 104. The pump radiation source 104 is adapted to emit electromagnetic radiation having a wavelength in the pump wavelength range. The pump radiation source can comprise at least one laser diode 105 and optics such as, for example, a lens 106 for forming a pump radiation beam 108 from the radiation emitted by the laser diode 104 and for directing the pump radiation beam 108 towards the active medium 101.

The irradiation of the active medium 101 with the pump radiation beam 108 can heat the active medium 101. For cooling the active medium 101, the active medium 101 can contact a heat sink 103 that is provided on a side of the active medium 101 opposite the output coupler.

A portion of the pump beam 108 can be absorbed in the active medium 101, creating a population inversion in the active medium 101. Thus, an amplification of electromagnetic radiation having the laser wavelength, and oscillating in the optical cavity 111, occurs in the active medium 101, and a laser beam 103 having the laser wavelength is formed.

A problem of the laser 100 according to the state of the art is that a first portion 109 of the pump beam 108 can be reflected on a surface of the active medium 101 facing the output coupler, and a second portion 110 of the pump beam 108 that enters the active medium 101, but is not absorbed in the active medium 101 during a single forward-backward pass due to a low optical density of a thin disk-shaped active medium 101, can leave the active medium 101 after being reflected at the coating 102. Thus, a part of the electromagnetic radiation emitted by the pump radiation source 104 can be lost for creating inverse population of the active medium, which may adversely affect the efficiency of the laser 100.

To reduce losses caused by reflection of portions 109, 110 of the pump beam 108, it has been proposed in the state of the art to use an anti-reflecting coating at pump wavelength on the surface of the active medium 101 facing the output coupler, and to use a concave mirror 107 for reflecting the portions 109, 110 of the pump beam 108 back towards the active medium 101. However, the effectiveness of this approach has been limited, since a part of the portions 109, 110 reflected towards the active medium 101 by the concave mirror 107 can be reflected for a second time on the front surface of the active medium 101 or at the coating 102. Moreover, a careful adjustment of the concave mirror 107 may be required.

Similar problems can also occur in optically pumped vertical external cavity surface emitting lasers, wherein a semiconductor structure is used as the active medium 101.

In view of these problems, it is an object of the present invention to provide a resonant cavity optically pumped laser wherein losses of pump radiation that are caused by reflection from the active medium can be reduced.

A resonant cavity optically pumped laser according to the present invention comprises an active medium, a first optical cavity, a pump radiation source, a second optical cavity, and a tuning means. The active medium has a pump absorption band at a pump wavelength range and a laser transition band at a laser wavelength. The first optical cavity comprises a first and a second laser radiation reflecting element. The active medium is provided in the first optical cavity. The pump radiation source is adapted for emitting a pump radiation beam comprising electromagnetic radiation having a wavelength in the pump wavelength range. The second optical cavity comprises a first and a second pump radiation reflecting element adapted for reflecting electromagnetic radiation having a wavelength in the pump wavelength range. The first pump radiation reflecting element is a partially reflective element. In particular, the first pump radiation element can be partially reflective for electromagnetic radiation having a wavelength in the pump wavelength range.. The first and second pump radiation reflecting elements are arranged in such a way that the active medium is also provided in the second optical cavity. The second optical cavity is arranged for receiving the pump radiation beam through the first pump radiation reflecting element. A first portion of the pump radiation beam is reflected from the first pump radiation reflecting element to form a first reflected beam. One or more second portions of the pump radiation beam are transmitted through the first pump radiation reflecting element after passage through the active medium and one or more reflections at the second pump radiation reflecting element. The one or more second portions of the pump radiation beam form a second reflected beam. The tuning means is adapted for tuning an optical path between the first and the second pump radiation reflecting elements and/or the wavelength of the pump radiation beam such that the second optical cavity is in a resonance with a wavelength of the pump radiation, providing destructive interference between the first and the second reflected beam.

The destructive interference between the first and the second reflected beam reduces the intensity of the pump radiation that is reflected away from the active medium. Instead, the electromagnetic radiation that is emitted by the pump radiation source can remain resonantly trapped in the second optical cavity and can be almost completely absorbed in the active medium. Thus, losses of pump radiation that do not participate in creating inverse population of the active medium can be reduced.

In some embodiments, the reflectivity of the second laser radiation reflecting element for electromagnetic radiation having the laser wavelength and the reflectivity of the second pump radiation reflecting element for electromagnetic radiation having a wavelength in the pump wavelength range can be greater than 95 %.

In some embodiments, the second laser radiation reflecting element can be as highly reflective at the laser wavelength as technologically possible. The first laser radiation reflecting element can have a partial reflectivity at the laser wavelength, the value of which can be adapted for optimal outcoupling of the laser radiation from the active medium. The first laser radiation reflecting element can comprise a single mirror element or a combination of a plurality of mirror elements.

In some embodiments, the active medium is a solid body having a first surface and a second surface. The first pump radiation reflecting element is provided in form of a first coating adapted for partially reflecting electromagnetic radiation having a wavelength in the pump wavelength range and for transmission of electromagnetic radiation having the laser wavelength. The first coating is formed on the first surface of the solid body. The second laser radiation reflecting element and the second pump radiation reflecting element are provided in form of a second coating adapted for reflecting both electromagnetic radiation having the laser wavelength and electromagnetic radiation having a wavelength in the pump wavelength range. The second coating is formed on the second surface of the solid body. Thus, the first and second pump radiation reflecting elements, and the second laser radiation reflecting element, can be provided in a convenient manner.

In some embodiments, the first and the second surface can be planar surfaces that are parallel to each other. In other embodiments, the second surface of the solid body can be of a convex shape centered with respect to the first surface of the solid body.

In some embodiments, the first coating can be adapted for both providing the first pump radiation reflecting element and the first laser radiation reflecting element (laser radiation output coupler), thus allowing the first and the second optical cavities to be provided within the same physical space.

In some embodiments, the tuning means comprises a temperature controller adapted for controlling the temperature of the solid body for tuning the optical path between the first pump radiation reflecting element and the second pump radiation reflecting element. Due to the thermal expansion of the solid body and temperature dependence of its refractive index, the temperature of the solid body has an influence on the optical path between the first and the second surface of the solid body. Therefore, temperature control of the solid body provides a convenient method of controlling the optical path between the pump radiation reflecting elements, hence controlling the optical path of the second optical cavity to be in a resonance condition with the pump radiation wavelength.

In some embodiments, the thickness of the solid body in the direction from the second surface to the first surface is smaller than in the perpendicular directions. Such geometry allows for one-dimensional heat transfer within the solid body along its thickness direction and helps to reduce thermal lensing in the active medium.

In some embodiments, the laser comprises a semiconductor structure. The semiconductor structure comprises a substrate and a distributed Bragg reflector. The distributed Bragg reflector comprises a plurality of semiconductor layers formed over a surface of the substrate and forms the second laser radiation reflecting element and the second pump radiation reflecting element. The active medium is a semiconductor active medium formed over the distributed Bragg reflector. Since the composition and arrangement of material layers in semiconductor structures can be precisely controlled, providing the active medium in form of a semiconductor structure allows an adaptation of features of the active medium such as, for example, the laser wavelength, to particular requirements.

In some embodiments, the semiconductor structure further comprises a coating formed above the semiconductor active medium, the coating forming the first pump radiation reflecting element and being transmissive for electromagnetic radiation having the laser wavelength. The transmissibility of the coating for electromagnetic radiation having the laser wavelength can be 95% or more.

In some embodiments, the coating formed above the semiconductor active medium can be transmissive for electromagnetic radiation at both the laser wavelength and the pump radiation wavelength. In some embodiments, a high transmissibility, for example a transmissibility of 99 % or more of the coating can be provided.

In some embodiments, in particular in embodiments wherein the coating formed above the semiconductor active medium is highly transmissive for electromagnetic radiation having a wavelength in the pump wavelength range, the laser further comprises a mirror provided at a distance to the semiconductor structure. The mirror is partially reflective for electromagnetic radiation having a wavelength in the pump wavelength range and transmissive for electromagnetic radiation having the laser wavelength. The mirror forms the first pump radiation reflecting element. In such embodiments, the semiconductor structure can have a structure corresponding to that of semiconductor structures employed in vertical external cavity surface emitting lasers according to the state of the art. This allows using existing semiconductor structures in a laser according to the present invention.

In some embodiments, the tuning means comprises an actuator for moving the mirror.

In some embodiments, the laser further comprises a partially transmissive output coupler mirror provided at a distance to the solid body, the mirror forming the first laser radiation reflecting element. In some embodiments, the first laser radiation reflecting element comprises a plurality of mirrors arranged for outcoupling the laser radiation power from the active medium.

In some embodiments, the first laser radiation reflecting element and the first pump radiation reflecting element are provided in form of a single optical element forming both the first laser radiation reflecting element and the first pump radiation reflecting element.

In some embodiments, the pump radiation source comprises one or more laser diodes. Laser diodes provide pump radiation with a high efficiency. Hence, using laser diodes in the pump radiation source allows for providing a high wall plug efficiency of the laser.

In some embodiments, the tuning means comprises a temperature controller adapted for controlling a temperature of the one or more laser diodes. Temperature control of laser diodes allows varying the wavelength of the radiation emitted by the laser diodes.

In some embodiments, the reflectivity of the first pump radiation reflecting surface is equal to $R_2 \exp(-2kL)$, with k being the absorption coefficient of the active medium for electromagnetic radiation having a wavelength in the pump radiation wavelength range, L being the thickness of the active medium along an optical axis of the second optical cavity and $R_2$ being a reflectivity of the second pump radiation reflecting element for electromagnetic radiation having a wavelength in the pump wavelength range.

In some embodiments, the reflectivity of the first pump radiation reflecting element for electromagnetic radiation having a wavelength in the pump wavelength range is in a range from 40 % to 85 %.

In some embodiments, the laser further comprises a sensor adapted for measuring an intensity of pump radiation reflected from the second optical cavity and a controller connected to the sensor and the tuning means. The controller is adapted for operating the tuning means such that the intensity of the pump radiation reflected from the second optical cavity is minimized. Thus, the tuning of the second optical cavity and/or the wavelength of the electromagnetic radiation emitted by the pump radiation source can be performed automatically.

A method of operating a resonant cavity optically pumped laser as described above comprises measuring an intensity of pump radiation reflected from the second optical cavity and operating the tuning means for tuning at least one parameter of the optical path (*nL*) between the first and the second pump radiation reflecting element and/or the wavelength λ of the pump radiation beam such that the second optical cavity is kept at resonance with the wavelength of pump radiation, thus providing the intensity of the pump radiation reflected from the second optical cavity is minimized..

Embodiments of the present invention will now be described with reference to the figures, wherein

Fig. 1 shows a schematic view of an optically pumped laser according to the state of the art;

Fig. 2a shows a schematic view of a resonant cavity optically pumped laser according to an embodiment of the present invention;

Fig. 2b shows a schematic view illustrating a passage of the pump radiation in the second optical cavity of the laser shown in Fig. 2a;

Fig. 3 shows a schematic view of a resonant cavity optically pumped laser according to another embodiment of the present invention;

Fig. 4a shows a schematic view of a resonant cavity optically pumped laser according to yet another embodiment of the present invention; and

Fig. 4b shows a schematic cross-sectional view of a semiconductor structure in the laser shown in

Fig. 4a.

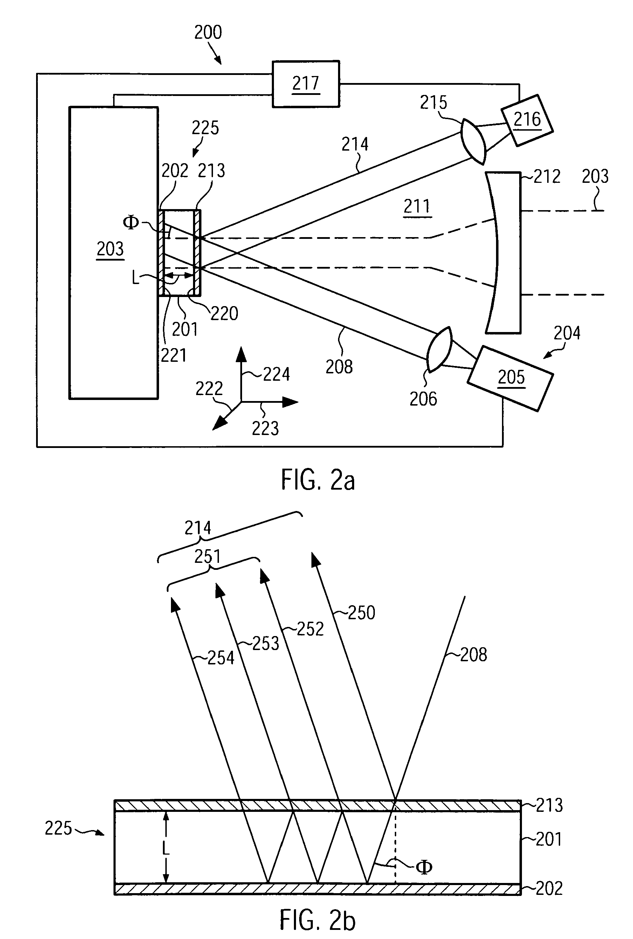

As per schematic view of Fig. 2a, a resonant cavity optically pumped laser 200 according to an embodiment of the present invention comprises an active medium 201. Similar to the active medium 101 described above with reference to Fig. 1, the active medium 201 has a pump absorption band comprising a pump wavelength range and a laser transition at a laser wavelength. The pump wavelength range is a portion of the active medium absorption spectrum wherein optical pumping of the active medium can efficiently be performed, for example, due to a large value of the absorption coefficient of the active medium 201 for electromagnetic radiation having a wavelength in the pump wavelength range. In some embodiments, the active medium 201 can be a solid body comprised of a solid laser material. For example, the active medium can comprise at least one from the following: Nd:YAG, Nd:YLF, Nd:YVO4 Yb:YAG, Yb: KGW, Yb:KYW, Cr:Al2O3 (ruby), Cr:BeAl2O4 (alexandrite), appropriately doped ZnS and ZnSe.

The solid body can have a first surface 220 and a second surface 221 which are substantially flat and parallel to each other. In Fig. 2a, a thickness direction denoted by reference numeral 223 extends in a direction from the second surface 221 to the first surface 220, the first surface 220 and the second surface 221 being perpendicular to the thickness direction 223. The thickness direction 223 can in some embodiments also be the direction of the optical axis of the laser. Reference numerals 222 and 224 denote first and second width directions, respectively, which are perpendicular to the thickness direction 223 and parallel to the first surface 220 and the second surface 221.

The thickness of the solid body in the thickness direction 223 can be chosen in accordance with a value $k$ of the pump radiation absorption coefficient of the active medium 201 to provide a number of effective passages of pump radiation inside the active medium 201 adapted for creating a reasonably uniform gain profile along the optical axis of the laser 200. In some embodiments the number N of effective round trip passages inside the active medium 201 can be within the range from 3 to 10. The relationship between features of the active medium 201 as well as the second optical cavity 225 and the number of effective roundtrip passages will be discussed below. In some embodiments, the thickness of the solid body can have a value in a range from 0,001 mm to 5 mm. There is no restriction for the sizes of the solid body in perpendicular directions 222 and 224. In some embodiments, the solid body can have a circular or rectangular cross-section perpendicular to the direction 223. In some embodiments, the solid body can have a disk shape wherein the thickness of the solid body is smaller than the minimum dimension of the solid body in the width directions 222, 224.

The laser 200 further comprises a first optical cavity 211 comprising a first and a second laser radiation reflecting element that are adapted for reflecting electromagnetic radiation having the laser wavelength of the active medium 201. The active medium 201 is provided in the first optical cavity 211.

The first laser radiation reflecting element can be provided in form of an output coupler mirror 212. The output coupler mirror 212 can have a coating that is partially reflective and partially transmissive for electromagnetic radiation having the laser wavelength, such that laser radiation can escape the first optical cavity 211, forming a laser beam 203. The coating can be formed on the side of the output coupler mirror 212 facing the active medium 201, and an antireflective coating can be formed on the side of the output coupler mirror 212 opposite the active medium 201. The output coupler mirror 212 can be provided on the side of the active medium 201 opposite the second side 221 of the active medium 201, such that the first side 220 is oriented towards the output coupler mirror 212.

In other embodiment, the output coupler mirror of the laser 200 can be provided in form of a coating that is partially reflective at the laser wavelength and also forms the first pump radiation partially reflecting element 213.

The second laser radiation reflecting element can be provided in form of a coating 202 formed on the second surface 221 of the active medium 201. The coating 202 is adapted for reflecting electromagnetic radiation having the laser wavelength. The coating 202 can be adapted for reflecting substantially all impinging electromagnetic radiation having the laser wavelength. The features of the coating 202 will be described in more detail below.

The coated side of the output coupler mirror 212 can have a concave shape such that the first optical cavity 211 formed by the output coupler mirror 212 and the coating 202 on the substantially flat second surface 202 of the active medium 201 is a stable laser cavity.

The laser 200 further comprises a pump radiation source 204 that is adapted for emitting a pump radiation beam 208 comprising electromagnetic radiation having a wavelength in the pump wavelength range of the active medium 201. In some embodiments, the pump radiation source 204 can comprise one or more lasers 205, for example one or more laser diodes. In some embodiments, the pump radiation source 204 can be adapted such that the pump radiation is substantially monochromatic, and the wavelength of the pump radiation emitted by the pump radiation source 202 can be variable within the pump wavelength range. In embodiments wherein the pump radiation source comprises one or more laser diodes 205, the wavelength of the pump radiation can be controlled by changing the temperature of the one or more laser diodes 205. This can be done by varying the drive current of the one or more laser diodes 205, or by controlling via cooling means such as, for example, a thermoelectric cooler connected to the one or more laser diodes 205.

The present invention, however, is not restricted to embodiments wherein the pump radiation source 204 comprises one or more laser diodes. In other embodiments, the pump radiation source 204 can comprise one or more lasers of a different type, for example one or more diode pumped solid state lasers. The present invention is not restricted to embodiments wherein the wavelength of the pump radiation source can be controlled.

Similar to the laser 100 described above with reference to Fig. 1, the pump radiation source 204 can comprise optics such as, for example, one or more lenses 206, for forming the pump beam 208 and for directing the pump beam 208 towards the active medium 201.

The laser 200 further comprises a second optical cavity 225. The second optical cavity 225 comprises a first and a second pump radiation reflecting element adapted for reflecting electromagnetic radiation having a wavelength in the pump wavelength range.

The fist pump radiation reflecting element can be provided in form of a coating 213 formed on the first surface 220 of the active medium 201. The coating 213 can be partially reflective and partially transmissive for electromagnetic radiation having a wavelength in the pump wavelength range, such that a portion of radiation having a wavelength in the pump wavelength range impinging on the coating 213 is transmitted through the coating 213, and a portion of radiation having a wavelength in the pump wavelength range is reflected at the coating 213.

The coating 213 can be highly transmissive (hence, of a low reflectivity) for electromagnetic radiation having the laser wavelength. A transmissivity of the coating 213 for electromagnetic radiation having the laser wavelength can be 99% or more, and the coating 213 can be adapted to reflect 1% or less of electromagnetic radiation having the laser wavelength incident thereon. Thus, electromagnetic radiation having the laser wavelength is substantially completely transmitted through the coating 213. A low reflectivity of the coating 213 for electromagnetic radiation having the laser wavelength can help to avoid the formation of a parasitic cavity for electromagnetic radiation having the laser wavelength between the coating 213 and the coating 202, in the case when the first optical cavity is made between the coating 202 and output coupler mirror 212.

In some embodiments, the coating 213 can combine the features of the first pump radiation reflecting element and for the first laser radiation reflecting element. In such embodiments, a separate output coupler 212 for laser radiation can be omitted..

The second pump radiation reflecting element can be provided in form of the coating 202 formed on the second surface 221 of the active medium 201. The coating 202 can be adapted to reflect substantially all impinging electromagnetic radiation having a wavelength in the pump wavelength range, and to additionally reflect substantially all impinging electromagnetic radiation having the laser wavelength. Thus, the coating 202 forms both the second laser radiation reflecting element of the first optical cavity 211 and the second pump radiation reflecting element of the second optical cavity 225.

In some embodiments, the coatings 213, 202 can be multilayer dielectric coatings, comprised of a plurality of layers of dielectric materials formed on the first surface 220 and the second surface 221 of the active medium 201, respectively. Desired reflection coefficients of each of the coatings 202, 213 can be provided by controlling the number of layers of dielectric materials, the thickness of the layers of dielectric materials and by selecting suitable materials..

The present invention is not restricted to embodiments wherein the coating 213 is a multilayer dielectric coating. In some embodiments, the coating 213 can be a single dielectric layer acting as an antireflective coating for electromagnetic radiation having the laser wavelength, and being partially reflective for electromagnetic radiation having a wavelength in the pump wavelength range.

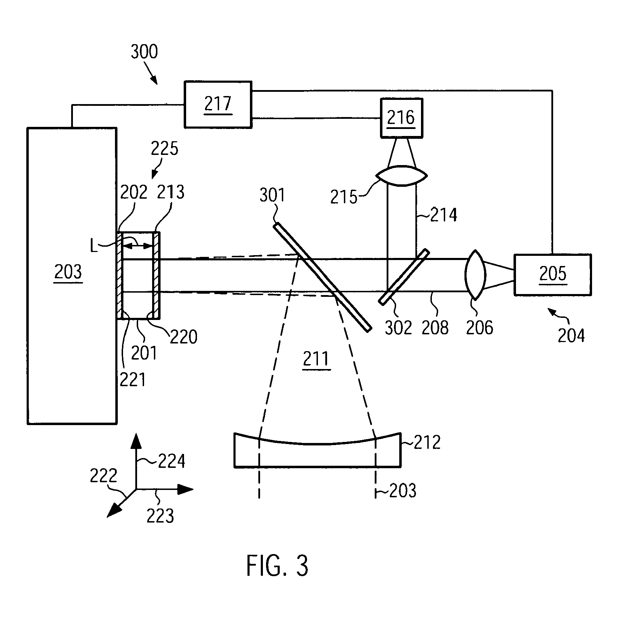

In some embodiments, reflection and transmission coefficients of the coatings 202, 213 can depend not only on the wavelength of electromagnetic radiation impinging on the coatings, but also on the angle of incidence of the electromagnetic radiation. In such embodiments, the coatings 202, 213 can be adapted such that desired reflection and transmission coefficients are obtained at the angles of incidence at which the laser beam 203 and the pump beam 208 impinge on the first surface 220 and the second surface 221 of the active medium 201. In particular, the coating 213 can be adapted for substantially transmitting electromagnetic radiation having the laser wavelength if the radiation impinges from a direction substantially perpendicular to the first surface 220, and to provide desired reflection and transmission coefficients for electromagnetic radiation having a wavelength in the pump wavelength range if the radiation impinges under the angle of incidence of the pump radiation beam 208. In the embodiment shown in Fig. 2a, the pump radiation beam 208 impinges obliquely on the first surface 220 and the second surface 221 of the active medium 201. In other embodiments, the pump radiation beam 208 can impinge substantially perpendicular to the first surface 220 and the second surface 221 of the active medium 201, as will be explained in more detail below with reference to Fig. 3.

Since the active medium 201 is provided between the first and the second laser radiation reflecting elements provided by the coating 202 and the output coupler mirror 212, and also between the first and the second pump radiation reflecting elements provided by the coating 202 and the coating 213, the active medium is provided both in the first optical cavity 211 and the second optical cavity 225. Therefore, the active medium 201 can interact both with electromagnetic radiation having the laser wavelength oscillating in the first optical cavity 211, and with electromagnetic radiation having a wavelength in the pump wavelength range oscillating in the second optical cavity 225. In particular, the active medium 201 can absorb electromagnetic radiation having a wavelength in the pump wavelength range oscillating in the second optical cavity 225, and can amplify electromagnetic radiation having the laser wavelength oscillating in the first optical cavity 211.

The pump radiation source 204 and the second optical cavity 225 are arranged such that the second optical cavity 225 receives the pump radiation beam 208 through the first pump radiation reflecting element provided by the coating 213. This can be done by directing the pump radiation beam 208 provided by the pump radiation source 204 towards the second optical cavity 225, as shown in Fig. 2a. In other embodiments, optical elements such as optical fibers, mirrors, prisms and/or lenses can be used for supplying the pump radiation beam 208 to the first pump radiation reflecting element of the second optical cavity.

A portion 214 of the pump radiation beam 208 can be reflected from the second optical cavity 225, at least if the second optical cavity 225 and/or the pump radiation source 204 are not optimally tuned, as will be explained in more detail below. The laser 200 can comprise a sensor 216 adapted for measuring the intensity of the pump radiation 214 reflected from the second optical cavity 225. The sensor 216 can be a sensor of a type known to persons skilled in the art, for example a photodiode. Optical elements such as, for example, a lens 215 can be used in some embodiments for focusing the reflected pump radiation 214 on the sensor 216 for increasing a sensitivity of the sensor 216 for the reflected pump radiation 214. In other embodiments, the lens 215 can be omitted.

The laser 200 can further comprise a temperature controller 203 that is thermally connected to the active medium 201, for example by attaching the active medium 201 to the temperature controller 203 such that the coating 202 abuts the temperature controller 203. Alternatively, a thermally conductive means such as, for example, a substrate comprising copper, and/or CVD diamond, or beryllium oxide ceramic can be provided between the active medium 201 and the temperature controller 203. The temperature controller 203 is adapted for controlling the temperature of the active medium 201. In some embodiments, the temperature controller 203 can comprise a thermoelectric cooler, wherein the temperature of the active medium 201 can be controlled by varying an electric current supplied to the thermoelectric cooler.

The laser 200 can further comprise a controller 217. The controller 217 is connected to the sensor 216 and receives a signal representative of the measured intensity of the reflected pump radiation 214. Additionally, the controller 217 can be connected to the temperature controller 203, and can be adapted to control the temperature of the active medium 201 on the basis of the intensity of the reflected pump radiation 214 measured by the sensor. Additionally, or alternatively, the controller 217 can be connected to the pump radiation source 204 for controlling the wavelength of the pump radiation source 204 on the basis of the measured intensity of the reflected pump radiation 214.

Fig. 2b shows a schematic view of the passage of the electromagnetic radiation received from the pump radiation source 204 in the second optical cavity 225. For simplicity, the pump radiation beam 208 from the pump radiation source 204, as well as several reflected portions 250, 252, 253, and 254 of the pump radiation beam 208 are denoted by lines, although the pump radiation beam 208 as well as the reflected portions 250, 252, 253, and 254 extend in the horizontal direction of Fig. 2b and substantially overlap with each other.

A portion of the pump radiation beam 208 is reflected by the coating 213 that forms the first pump radiation reflecting element of the second optical cavity 225 and forms a first reflected beam 250.

Another portion of the pump radiation beam 208 enters the active medium 201 provided in the second optical cavity 225. In the active medium, absorption of the pump radiation beam 208 occurs. However, a part of the pump radiation beam 208 can pass the active medium 201, and can be reflected at the coating 202 that forms the second pump radiation reflecting element of the second optical cavity 225. After a second passage through the active medium 201, a part of the pump radiation reflected at the coating 202 that is not absorbed during the second passage through the active medium 201 arrives at the coating 213. Since the coating 213 is partially transmissive for the pump radiation, a portion 252 of the pump radiation reflected at the coating 202 that is not absorbed in the active medium 201 can be transmitted through the coating 213.

Since the coating 213 is partially reflective, a portion of the pump radiation beam 208 reflected at the coating 202 can be reflected back into the active medium 201, and multiple reflections of portions of the pump radiation beam 208 at the coating 202 can occur.

In Fig. 2b, reference numeral 253 denotes a portion of the pump radiation beam 208 that is transmitted through the coating 213 after two reflections at the coating 202, and reference numeral 254 denotes a portion of the pump radiation beam 208 that is transmitted through the coating 213 after three reflections at the coating 202. Portions of the pump radiation beam 208 that are transmitted through the coating 213 after more than three reflections at the coating 202 can also occur.

Since, however, a part of the pump radiation beam 208 is absorbed whenever the pump radiation beam 208 passes through the active medium, and a part of the pump radiation beam 208 is transmitted through the coating 213 whenever a portion of the pump radiation beam 208 reflected at the coating 202 impinges on the coating 213, the amplitude of portions of the pump radiation beam 208 reflected at the coating 202 and transmitted through the coating 213 decreases with the number of reflections at the coating 202.

The portions 252, 253, 254 of the pump radiation beam 208 that are transmitted through the coating 213 after one or more reflections at the coating 202 superimpose with each other and form a second reflected beam 251. The first reflected beam 250 and the second reflected beam 251 interfere with each other. Therefore, the intensity of the pump radiation 214 reflected from the second optical cavity 225 is influenced by the phase difference between the first reflected beam 250 and the second reflected beam 251. If the phase difference between the first reflected beam 250 and the second reflected beam 252 is, at least approximately, 180°, destructive interference between the first reflected beam 250 and the second reflected beam 251 is reached, and the intensity of the reflected pump radiation 214 is a minimum. Therefore, losses of pump radiation that are caused by reflection of pump radiation from the second optical cavity 225 can be reduced.

Moreover, if the reflectivity $R_1$ of the first pump radiation reflecting element 213 at pump wavelength is, at least approximately,

$$R_1 = R_2 \cdot exp(-2kL), \qquad\qquad (Eq.1)$$

where $R_2$ is the reflectivity of the second pump radiation reflecting element 202 at the pump wavelength, $L$ is the distance between the first 213 and second 202 pump radiation reflecting elements, and $k$ is the absorption coefficient of the active medium 201 at pump wavelength, the destructive interference between the first reflected pump beam 250 and the second reflected pump beam 251 reduces reflected pump radiation 214 to a very low level, or to substantially zero. The condition for destructive interference of reflected pump beams 250 and 251 is, at the same time, the condition for the second optical cavity 225 to be tuned in a resonance with the pump radiation beam 208. This condition reads:

$$2\,n\,L\,cos\,\phi = m\,\lambda, \qquad\qquad (Eq.\ 2)$$

with n being the refractive index of the active medium 201 for electromagnetic radiation having a wavelength in the pump wavelength range, $\phi$ being the angle of propagation of the pump radiation 208 in the second optical cavity 225 with respect to the perpendicular to the reflecting surfaces of the first 213 and the second 202 pump radiation reflecting element, $\lambda$ being the pump radiation wavelength, and m being an integer. In such condition, the pump radiation is reflected at minimum from the second optical cavity 225, is resonantly trapped in the second optical cavity 225 and gets absorbed to a large extent. Almost complete absorption of the pump radiation can be obtained if the second pump radiation reflecting element 202 is made as highly reflective as possible ($R_2 \cong 1$) for electromagnetic radiation having a wavelength in the pump wavelength range. In practical sense, R2 reflectivity can be made for example 0.99 (99%) or higher.

The actual minimum value of the reflected pump radiation from the second optical cavity 225 in the resonance condition as per Eq. 2 is dependent on the ratio between the spectral width of the pump radiation $\delta\lambda_p$ and the spectral width $\Delta\lambda_c$ of a resonance peak of the second optical resonator within the pump radiation wavelength range. For cases when

$$\Delta\lambda_c/\delta\lambda_p \gg 1 \qquad\qquad (Eq.3),$$

the pump radiation power reflected from the second optical cavity 225 can be as low as in the range from 0.1% to 2% of the incident pump radiation power. The spectral width $\Delta\lambda_c$ of the resonance peak of the second optical cavity 225 is a function of the optical path of the second optical cavity 225 and the reflectivity of the first and the second pump radiation reflecting elements 213, 202 and, thus, the Eq. 3 can be satisfied with an appropriate choice of these parameters.

At the above resonance condition (Eq. 2) and with $R_2 = 1$, the effective number of passages $N$ of the pump radiation inside the second optical cavity 225 until the pump radiation is getting almost completely absorbed equals approximately

$$N = \pi\sqrt{R_1}\,/(1 - R_1) \cong \pi\exp(-kL)/(1 - \exp(-2kL)) \qquad \text{(Eq. 4)}$$

For example, if $R_1 = exp(-2kL) = ii0.75$ (i.e. in single forward-backward pass the active medium 201 absorbs only 25% of the pump radiation), and $R_2 = 1$ (i.e., substantially complete reflection of the pump radiation at the second pump radiation reflecting element 202), the pump radiation until being almost completely absorbed circulates effectively approximately 10 round trips inside the second optical cavity 225 . These multiple passes of the pump radiation inside the second optical cavity 225 make the absorbed pump radiation uniformly distributed along the cavity thickness direction 223, thus allowing a uniform population inversion/gain distribution along the optical axis of the first optical cavity 211. This can help to improve the effectiveness of lasers operating on three level schemes.

The phase difference between the first reflected beam 250 and the second reflected beam 251 can be affected by the distance between the coatings 202, 213, that is the thickness $L$ of the active medium 201. Additionally, as it is seen from Eq. 2 above), the phase difference between the first reflected beam 250 and the second reflected beam 251 can be influenced by a change of the refractive index n of the active medium 201 for electromagnetic radiation having a wavelength in the pump wavelength range caused, for example, by a change of the temperature of the active medium 201, of the angle $\phi$ of propagation of the pump radiation inside the active medium 201, accordingly of the incident angle of the beam 208 on the second optical cavity 225, and of the wavelength $\lambda$ of the electromagnetic radiation emitted by the pump radiation source 204.

In some embodiments of the present invention, the phase difference between the first reflected beam 250 and the second reflected beam 251 can be controlled by varying the temperature of the active medium 201, for example by means of the temperature controller 203. Due to thermal expansion of the active medium 201 and the temperature dependence of its refractive index n, an increase of the temperature of the active medium 201 can lead to an increase of the optical path $nL$ between the coatings 202, 213. A reduction of the temperature of the active medium 201 can lead to a reduction of the optical path of the pump radiation in the active medium 201.

Control of the temperature controller 203 can be effected by the control unit 217 on the basis of the intensity of the reflected pump radiation 214 measured by the sensor 216. The control unit 207 can control the temperature of the active medium 201 such that the intensity of the reflected pump radiation 214 is minimized. In embodiments wherein the temperature controller 203 comprises a thermoelectric cooler, the control unit 207 can control an electric current supplied to the thermoelectric cooler to minimize the intensity of the reflected pump radiation 214. For this purpose, a known optimization algorithm can be used.

In further embodiments, the phase difference between the first reflected beam 250 and the second reflected beam 251 can be controlled by varying the wavelength of the electromagnetic radiation emitted by the pump radiation source 204, using one of the techniques described above. In embodiments wherein the wavelength of the electromagnetic radiation emitted by the pump radiation source 204 can be controlled by varying the temperature of one or more laser diodes provided in the pump radiation source 204, this can be done by controlling the drive current of the one or more laser diodes and/or by means of a temperature controller thermally connected to the one or more laser diodes such as, for example, a thermoelectric cooler.

In other embodiments, different known means for wavelength control of the pump radiation source 204 provided in the pump radiation source 204 such as, for example, a volume Bragg reflector/grating that can be temperature controlled by the control unit 217 can be used.

In embodiments wherein the wavelength of the electromagnetic radiation emitted by the pump radiation source 204 is controlled, the means for wavelength control of the pump radiation source 204 can be controlled for minimizing the intensity of the reflected pump radiation 214 measured by the sensor 216 in accordance with a known minimization algorithm.

In still further embodiments, the control unit 217 can be adapted to control both the temperature of the active medium 201 and the wavelength of the electromagnetic radiation emitted by the pump radiation source 204.

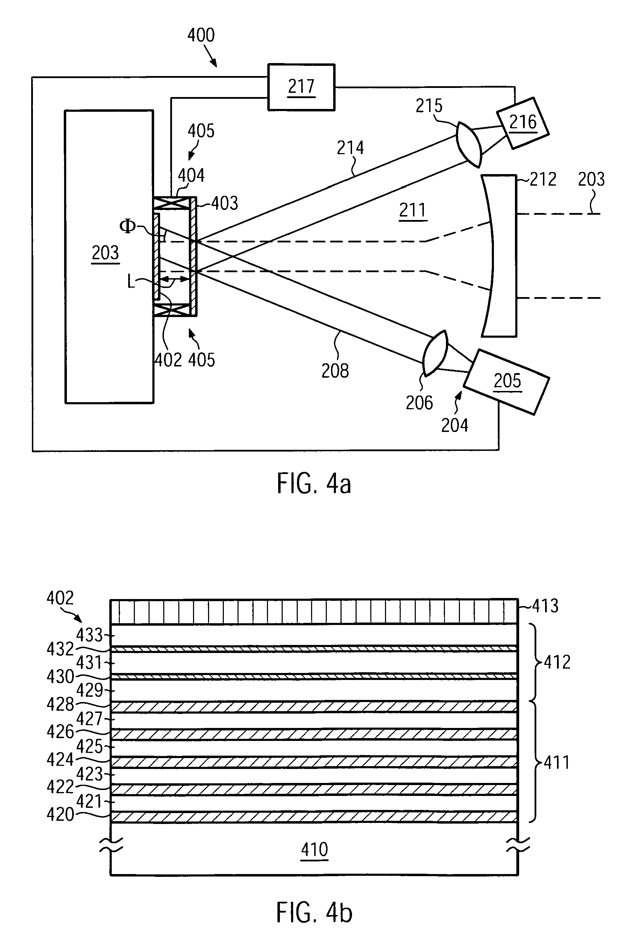

Further embodiments of the present invention will be described with reference to Figs. 3, 4a and 4b. For convenience, in Figs. 3, 4a and 4b, the same reference numerals as in Figs. 2a and 2b are used to denote corresponding components. Unless indicated otherwise, components shown in Figs. 3, 4a and 4b, and denoted by reference numerals that are also used in Figs. 2a and 2b, can have features corresponding to those of the respective components described above with reference to Figs. 2a and 2b.

Fig. 3 shows a schematic view of a laser 300 according to another embodiment of the present invention. The laser 300 comprises an active medium 201, a first optical cavity 211 comprising a first laser radiation reflecting element provided in form of an output coupler mirror 212, and a second laser radiation reflecting element provided in form of a coating 202 on a second surface 221 of the active medium 201. The optical axis of the first optical cavity 211 is folded by reflecting the radiation at the laser wavelength with a wavelength selective mirror 301 placed at an angle with respect to the radiation outcoming from the active medium 201. In particular, the mirror 301 can be placed at the angle of 45 degrees with respect to the perpendicular of the surfaces 220, 221.

The wavelength selective mirror 301 can be provided for reflecting electromagnetic radiation having the laser wavelength and propagating from the active medium 201 in a direction perpendicular to the surfaces 220, 221 towards the output coupler 212, and for reflecting electromagnetic radiation having the laser wavelength reflected at the output coupler mirror 212 towards the active medium 201. The wavelength selective mirror 301 can be adapted to reflect substantially all electromagnetic radiation having the laser wavelength impinging thereon, and to transmit substantially all electromagnetic radiation having a wavelength in the pump wavelength range. Thus, losses of laser radiation and pump radiation caused by the wavelength selective mirror 301 can be reduced or substantially avoided.

The laser 300 further comprises a pump radiation source 204 that can, in some embodiments, comprise one or more lasers 205, for example laser diodes, and/or one or more lenses 206. Additionally, the laser 300 comprises a second optical cavity 225 comprising a first pump radiation reflecting element provided in form of a coating 213 formed on a first surface 220 of the active medium 201, and a second pump radiation reflecting element provided in form of the coating 202. Moreover, the laser 300 can comprise a sensor 216 for measuring an intensity of pump radiation reflected at the second optical cavity 225, the sensor 216 being connected to a controller 217 and, optionally, one or more elements for focusing reflected pump radiation 214 onto the sensor 216 such as, for example, a lens 215. The control unit 217 can be connected to a temperature controller 203 thermally connected to the active medium 201 for controlling the temperature of the active medium 201, and can, additionally or alternatively, be connected to the pump radiation source 204 for controlling the wavelength of a pump radiation beam 208 emitted by the pump radiation source 204.

In the laser 300, the pump radiation source 204 and the active medium 201 are arranged such that the pump radiation beam 208 impinges on the active medium 201 and the coatings 202, 213 from a direction that is perpendicular to the first surface 220 and the second surface 221 of the active medium 201. Thus, the pump radiation beam 208 enters the second optical cavity 225 from a direction that is parallel to the optical axis of the second optical cavity 225.

In some embodiments, the pump radiation source 204 can be adapted to emit the pump radiation beam 208 in the direction perpendicular to the surfaces 220, 221. In other embodiments, the pump radiation source 204 can emit the pump radiation beam 208 into a different direction, and optical elements such as optical fibers, mirrors, prisms and/or lenses can be used for supplying the pump radiation beam 208 to the second optical cavity 225 from a direction perpendicular to the surfaces 220,221.

Since the pump radiation beam 208 impinges on the active medium 201 from a direction perpendicular to the surfaces 220, 221, pump radiation 214 that is reflected from the second optical cavity 225 also propagates in a direction perpendicular to the surfaces 220, 221. A partially reflecting mirror 302 can be used for reflecting a portion of the reflected pump radiation 214 towards the sensor 216 such that the intensity of the reflected pump radiation 214 can be measured by means of the sensor 216. The partially reflecting mirror 302 is adapted for reflecting a small portion and transmitting a greater portion of impinging radiation having a wavelength in the pump wavelength range. Additionally, in some embodiments, the partially reflecting mirror 302 can be adapted for partially reflecting electromagnetic radiation having a wavelength outside the pump wavelength range.

In some embodiments, the reflectivity of the partially reflecting mirror 302 for electromagnetic radiation having a wavelength in the pump wavelength range can be reasonably low as to be just enough for detecting the reflected pump radiation at the second optical cavity by the sensor 216 and, hence, to minimize losses of pump radiation caused by reflecting the pump radiation beam 208 emitted by the pump radiation source 204 at the partially reflecting mirror 302. For example, the reflectivity of the partially reflecting mirror 302 for electromagnetic radiation having a wavelength in the pump wavelength range can have a value in a range from 0.1 % to 2%.

In the laser 300, the pump radiation beam 208 impinges on the second cavity 225 comprising the active medium 201 from a direction that is substantially perpendicular to the surfaces 220, 221 covered by the coatings 213, 202, respectively, i.e., the angle $\phi$ in Eq. 2 is approximately zero. Therefore, pump radiation reflected in the second optical cavity 225 propagates in a direction opposite the propagation direction of the pump radiation beam 208. Thus, all portions of the pump radiation beam 208 reflected in the second optical cavity 225 overlap substantially completely with each other and interfere with each other.

In embodiments wherein the pump radiation beam 208 impinges obliquely on the second optical cavity (i.e. the angle $\phi$ in the above Eq. 2 differs from zero), as shown in Figs. 2a and 2b, the portions of the pump radiation beam 208 reflected in the second optical cavity 225 can be parallel shifted relative to each other such that they do not completely overlap. This can increase losses caused by reflection of the pump radiation beam 208 at the second optical cavity 225, since the non-overlapping parts of the reflected portions of the pump radiation beam may be incompletely extinguished by destructive interference.

Therefore, the laser 300 may help to further reduce losses of pump radiation caused by reflection of the pump radiation beam 208.

Additionally, supplying the pump radiation beam 208 to the active medium 201 from a direction perpendicular to the surfaces 220, 221 of the active medium 201 can help to irradiate the active medium 201 with the pump radiation beam 208 at highest pump power density, due to a reduction of spreading the pump radiation in a lateral direction caused by portions of the pump radiation beam 208 that pass the active medium 201 on the sides.

For some applications, however, supplying the pump radiation beam 208 from a direction oblique to the surfaces 220, 221 of the active medium 201, as described above with reference to Figs. 2a and 2b, can be advantageous, since it allows to reduce the number of optical components in the laser 200.

Fig. 4a shows a laser 400 according to another embodiment of the present invention. The laser 400 comprises a semiconductor structure 402. A schematic cross-sectional view of the semiconductor structure 402 is shown in Fig. 4b.

The semiconductor structure 402 comprises a substrate 410. The substrate 410 can be a semiconductor substrate comprising a semiconductor material such as, for example gallium arsenide (GaAs). In other embodiments, the substrate 410 can comprise a non-semiconducting material such as, for example, sapphire.

Over the substrate 410, a distributed Bragg reflector 411 is formed. The distributed Bragg reflector 411 comprises a plurality of alternating layers 420-428 comprised of materials having a different index of refraction. In Fig. 4b, layers of the distributed Bragg reflector 411 comprised of a first material are denoted by even reference numerals, and layers comprised of a second material are denoted by odd reference numerals. In some embodiments, the first and the second material can be semiconductor materials. For example, the first material can comprise aluminum arsenide (AlAs), and the second material can comprise aluminum gallium arsenide (AlGaAs).

Over the distributed Bragg reflector 411, a semiconductor active medium 412 is formed. In some embodiments, the semiconductor active medium 412 can comprise one or more quantum well structures. The quantum well structures can be provided by layers 430, 432 of a semiconductor material formed between layers 429, 431, 433 of another semiconductor material. In some embodiments, the layers 430, 432 can comprise aluminum gallium arsenide, and the layers 429, 431, 433 can comprise gallium arsenide. While Fig. 4b shows two quantum well structures, in other embodiments, a different number of quantum well structures can be provided. In some embodiments, quantum dot semiconductor structures can be used instead of quantum well structures.

Similar to the active medium 201 described above with reference to Figs. 2a and 2b, the semiconductor active medium 412 has an absorption band at a pump wavelength range and a laser transition at a laser wavelength. Irradiation of the active medium 201 with electromagnetic radiation having a wavelength within the pump wavelength range can create a population inversion in the semiconductor active medium, such that electromagnetic radiation having the laser wavelength can be amplified by the process of stimulated emission.

The distributed Bragg reflector 411 can be adapted to reflect both electromagnetic radiation having the laser wavelength and electromagnetic radiation having a radiation in the pump wavelength range. A reflectivity of the distributed Bragg reflector for the electromagnetic radiation having the laser wavelength and the electromagnetic radiation having a wavelength in the pump wavelength range can be greater than 90 %. The reflectivity of the distributed Bragg reflector 411 can be controlled by adapting the thickness of each of the layers 420 to 428 and, optionally, by adapting the index of refraction of some or all of the layers 420 to 428. In embodiments wherein some of the layers 420 to 428 comprise aluminum gallium arsenide, the index of refraction of the aluminum gallium arsenide layers can be controlled by adapting the aluminum content and the gallium content of the aluminum gallium arsenide layers.

Over the semiconductor active medium 412, a coating 413 can be formed. The coating 413 can comprise one or more layers of a dielectric material. In some embodiments, the coating 413 can be adapted to function as an antireflective coating for electromagnetic radiation having the laser wavelength, and as partially reflecting mirror for electromagnetic radiation having a wavelength in the pump wavelength range.

In other embodiments, the coating 413 can be adapted to function as an antireflective coating both for electromagnetic radiation having the laser wavelength, and for electromagnetic radiation having a wavelength in the pump wavelength range.

The semiconductor structure 402 can be thermally connected to a temperature controller 203 adapted for controlling the temperature of the semiconductor structure 402. In some embodiments, the temperature controller 203 can comprise a thermoelectric cooler.

The laser 400 further comprises a first optical cavity 211. The first optical cavity 211 comprises a first laser radiation reflecting element provided in form of an output coupler mirror 212, and a second laser radiation reflecting element provided in form of the distributed Bragg reflector 411 in the semiconductor structure 402. Moreover, the laser 400 comprises a pump radiation source 204 adapted to provide a pump radiation beam 208 comprising electromagnetic radiation having a wavelength in the pump wavelength range. In some embodiments, the pump radiation source 204 can comprise one or more lasers 205 and, optionally, one or more lenses 206.

The laser 400 further comprises a second optical cavity 405. In some embodiments the second optical cavity 405 comprises a first pump radiation reflecting element provided in form of the coating 413 over the semiconductor active medium in the semiconductor structure 402 , and a second pump radiation reflecting element provided in form of the distributed Bragg reflector 411 in the semiconductor structure 402, similar to the second optical cavity 225 described above with reference to Figs. 2a, 2b and 3.

In other embodiments, the second optical cavity 405 comprises a first pump radiation reflecting element provided in form of a mirror 403, as shown in Fig. 4a. The mirror 403 is adapted for partial reflection of electromagnetic radiation having a wavelength in the pump wavelength range impinging on the mirror 403. Moreover, the mirror 403 is adapted for transmitting electromagnetic radiation having the laser wavelength. A reflectivity of the mirror 403 for electromagnetic radiation having the laser wavelength can be less than 0.2%. In some embodiments, the mirror 403 can be a wavelength selective dielectric mirror.

The second optical cavity 405 further comprises a second pump radiation reflecting element provided in form of the distributed Bragg reflector 411 of the semiconductor structure 412.

The surface of the substrate 410 of the semiconductor structure 402 on which the distributed Bragg reflector 411 is formed, as well as the reflecting surface of the mirror 403 can be flat. Thus, the pump radiation reflecting elements of the second optical cavity 405 have planar reflecting surfaces.

The semiconductor structure 402 and the mirror 403 can be arranged such that the reflective surface of the mirror 403 and the surface of the substrate 410 on which the distributed Bragg reflector 411 and the semiconductor active medium 412 are formed are parallel to each other, the distributed Bragg reflector 411 and the semiconductor active medium 412 facing the mirror 403, the substrate 410 being on a side of the semiconductor active medium 412 opposite the mirror 403. The mirror 403 can be provided at a distance to the semiconductor structure 402. A diameter of the mirror 403 can be greater than a diameter of the semiconductor structure 402.

The laser 400 can further comprise an actuator 404 for varying a distance between the mirror 403 and the semiconductor structure 402. Thus, the second optical cavity 405 can be tuned. In some embodiments, the actuator 404 comprises a piezoelectric element.

The pump radiation source 204 and the second optical resonator 405 are arranged such that the semiconductor active medium 411 receives the pump radiation from the pump radiation source 204 through the mirror 403. This can be done by directing the pump radiation beam 208 from the pump radiation source 204 towards the semiconductor structure 402 from a direction oblique to the surface of the substrate of the semiconductor structure 402, as shown in Fig. 4a. In other embodiments, an arrangement as described above with reference to Fig. 3 can be provided, wherein a partially reflecting mirror 302 and a wavelength selective mirror 301 are used to direct the pump radiation beam 208 to the second optical cavity 405 from a direction that is perpendicular to the reflecting surface of the mirror 403 as well as to the surface of the substrate 410 on which the distributed Bragg reflector 411 is formed.

The laser 400 further comprises a sensor 216 for measuring an intensity of pump radiation 214 from the pump radiation source 205 that is reflected from the second optical cavity 405 and, optionally, a lens 215 for focusing the reflected pump radiation 214 on the sensor 216. The sensor 216 is connected to a controller 217. The controller 217 can be connected to the actuator 404 for tuning the second optical cavity 405 in accordance with the intensity of the reflected pump radiation 214 measured by the sensor 216. Additionally, or alternatively, the controller 217 can be connected to the pump radiation source 204 for controlling a wavelength of the electromagnetic radiation emitted by the pump radiation source 204.

Similar to the second optical cavity 225 described above with reference to Figs. 2a, 2b and 3, a reflection of portions of the pump radiation beam 208 can occur both at the reflective surface of the mirror 403 and at the distributed Bragg reflector 411, and multiple reflections at the reflective surface of the mirror 403 and the distributed Bragg reflector 411 can also occur.

A first portion of the pump radiation beam 208 reflected at the mirror 403 forms a first reflected beam. One or more second portions of the pump radiation beam 208 are transmitted through the mirror 403 after passage through the semiconductor active medium 412 and one or more reflections at the distributed Bragg reflector 411, and form a second reflected beam. By adjustment of the distance between the mirror 403 and the semiconductor structure 402 and/or by adjustment of the wavelength of the pump radiation source 204, the phase difference between the first reflected pump beam and the second reflected pump beam can be controlled such that destructive interference between the first reflected beam and the second reflected beam is obtained. This can be done by the controller 217 on the basis of the intensity of the reflected pump radiation 214 measured by the sensor 216, as described above with reference to Figs. 2a and 2b.

As already mentioned above, in some embodiments, the mirror 403 and the actuator 404 can be omitted, and the coating 413 can be replaced by a coating partially reflective for electromagnetic radiation having a wavelength in the pump wavelength range and transmissive for electromagnetic radiation having the laser wavelength, similar to the coating 213 described above with reference to Figs. 2a and 2b. In such embodiments, the pump radiation reflecting elements of the second optical cavity are provided by the distributed Bragg reflector 411 and the coating formed over the semiconductor active medium 412. In such embodiments, the second optical cavity 405 can be tuned by varying the temperature of the semiconductor structure 402 by means of the temperature controller 203, as described above with respect to Figs. 2a and 2b.

In other embodiments, the semiconductor structure 402 can be replaced by a solid body formed of an active medium, similar to the active medium 201 described above with reference of Figs. 2a and 2b. On a first side of the solid body facing the mirror 403, a coating that is an antireflective coating both for electromagnetic radiation having a wavelength in the pump wavelength range and for electromagnetic radiation having the laser wavelength can be formed. On a second side of the solid body opposite the mirror 403, a coating similar to the coating 202 described above with reference to Figs. 2a and 2b can be formed. In such embodiments, the pump radiation reflecting elements of the second cavity 405 are provided by the mirror 403 and the coating on the second side of the solid body. Tuning of the second optical cavity in resonance with pump radiation wavelength can be effected by operating the actuator 404.

The present invention is not limited to embodiments wherein the second laser radiation reflecting element and the second pump radiation reflecting element are provided in form of a single coating 202 or a single distributed Bragg reflector 411. In other embodiments, two coatings or two distributed Bragg reflectors, respectively, can be formed on top of each other, wherein one of the coatings or distributed Bragg reflectors, respectively, forms the second laser radiation reflecting element, and the other of the coatings or distributed Bragg reflectors, respectively, forms the second pump radiation reflecting element.

## Claims

1. Resonant cavity optically pumped laser (200, 300, 400), comprising:

   an active medium (201, 412) having a pump absorption band at a pump wavelength range and a laser transition band at a laser wavelength;
   a first optical cavity (211) comprising a first (212) and a second (202, 411) laser radiation reflecting element adapted for reflecting electromagnetic radiation having the laser wavelength, the active medium (201, 412) being provided in the first optical cavity (211); and
   a pump radiation source (204) adapted for emitting a pump radiation beam (208) comprising electromagnetic radiation having a wavelength in the pump wavelength range;
   **characterized by**
   a second optical cavity (225, 405) comprising a first (213, 403) and a second (202, 411) pump radiation reflecting element adapted for reflecting electromagnetic radiation having a wavelength in the pump wavelength range;
   wherein the first pump radiation reflecting element (213, 403) is a partially reflective element, the active medium (201, 412) is provided in the second optical cavity (225, 405) and the second optical cavity (225, 405) is arranged for receiving the pump radiation beam (208) through the first pump radiation reflecting element (213, 403),
   wherein a first portion of the pump radiation beam (208) is reflected from the first pump radiation reflecting element ((213, 403) to form a first reflected beam (250), and wherein one or more second portions (252, 253, 254) of the pump radiation beam (208) are transmitted through the first pump radiation reflecting element (213, 403) after passage through the active medium (201, 412) and one or more reflections at the second pump radiation reflecting element (202, 411), the one or more second portions (252, 253, 254) of the pump radiation beam (208) forming a second reflected beam (251); and
   tuning means (203, 404) for tuning an optical path between the first (213, 403) and the second (202, 411) pump radiation reflecting element and/or the wavelength of the pump radiation beam (208) such that the second optical cavity (225, 405) is in a resonance with a wavelength of the pump radiation beam (208), to provide for resonance trapping of the pump radiation inside the second optical cavity and for destructive interference between the first (250) and the second (251) reflected beams from the second optical cavity.

2. A laser (200, 300) as in claim 1, wherein the reflectivity of the second laser radiation reflecting element (202) for electromagnetic radiation having the laser wavelength and the reflectivity of the second pump radiation reflecting element (202, 411) for electromagnetic radiation having a wavelength in the pump wavelength range are greater than 95%.

3. A laser (200, 300) as in claim 1 or 2, wherein the active medium (201) is a solid body having a first surface (220) and a second surface (221),
   the first pump radiation reflecting element being provided in form of a first coating (213) adapted for partially reflecting electromagnetic radiation having a wavelength in the pump wavelength range and for transmitting electromagnetic radiation having the laser wavelength, the first coating (213) being formed on the first surface (220) of the solid body;
   the second laser radiation reflecting element and the second pump radiation reflecting element being provided in form of a second coating (202) adapted for reflecting both electromagnetic radiation having the laser wavelength and electromagnetic radiation having a wavelength in the pump wavelength range, the second coating (202) being formed on the second surface (221) of the solid body.

4. A laser (200, 300) as in claim 3, wherein the tuning means comprises a temperature controller (203) adapted for controlling a temperature of the solid body for tuning the optical path between the first pump radiation reflecting element (213) and the second pump radiation reflecting element (220).

5. A laser (400) as in claim 1, comprising a semiconductor structure (402) comprising:

a substrate (410); and
a distributed Bragg reflector (411) comprising a plurality of semiconductor layers (420-428) formed over a surface of the substrate (410), the distributed Bragg reflector (411) forming the second laser radiation reflecting element and the second pump radiation reflecting element;
the active medium being a semiconductor active medium (412) formed over the distributed Bragg reflector.

6. A laser (400) as in claim 5, wherein the semiconductor structure further comprises:

a coating formed over the semiconductor active medium, the coating forming the first pump radiation reflecting element and being transmissive for electromagnetic radiation having the laser wavelength.

7. A laser (400) as in claim 5, further comprising:

a mirror (403) provided at a distance to the semiconductor structure (402), the mirror (403) being partially reflective for electromagnetic radiation having a wavelength in the pump wavelength range and transmissive for electromagnetic radiation having the laser wavelength, the mirror (403) forming the first pump radiation reflecting element.

8. A laser (400) as in claim 7, wherein the tuning means comprises an actuator (404) adapted for moving the mirror (403).

9. A laser (200, 300, 400) as in any of claims 1 to 8, further comprising a partially transmitting output coupler mirror (212) provided at a distance to the solid body, the output coupler mirror (212) forming the first laser radiation reflecting element.

10. A laser as in any of claims 1 to 8, wherein the first laser radiation reflecting element and the first pump radiation reflecting element are provided in form of a single optical element forming both the first laser radiation reflecting element and the first pump radiation reflecting element.

11. A laser (200, 300, 400) as in any of claims 1 to 10, wherein the pump radiation source (204) comprises one or more laser diodes (205).

12. A laser (200, 300, 400) as in claim 11, wherein the tuning means comprises a temperature controller adapted for controlling a temperature of the one or more laser diodes (205).

13. A laser (200, 300, 400) as in any of claims 1 to 12, wherein a reflectivity of the first pump radiation reflecting element (213, 403) is equal to $R_2 \, exp(-2kL)$, with $k$ being the absorption coefficient of the active medium (201, 412) for electromagnetic radiation having a wavelength in the pump radiation wavelength range, $L$ being the thickness of the active medium (201, 412) along an optical axis of the second optical resonator (225, 405) and $R2$ being a reflectivity of the second pump radiation reflecting element (202, 411) for electromagnetic radiation having a wavelength in the pump wavelength range.

14. A laser (200, 300, 400) as in claim 13, wherein the reflectivity of the first pump radiation reflecting element (213, 403) for electromagnetic radiation having a wavelength in the pump wavelength range is in a range from 40% to 85%.

15. A laser (200, 300, 400) as in any of claims 1 to 14, further comprising:

a sensor (216) adapted for measuring an intensity of pump radiation (214) reflected from the second optical cavity (225, 405); and
a controller (207) connected to the sensor (206) and the tuning means (203, 404), the controller (207) being adapted for operating the tuning means (203, 404) such that the intensity of the pump radiation (214) reflected from the second optical cavity (225, 405) is minimized.

16. A method of operating a resonant cavity optically pumped laser (200, 300, 400) according to any of claims 1 to 15, comprising:

measuring an intensity of pump radiation reflected from the second optical cavity (225, 405); and
operating the tuning means (203, 404) for tuning at least one parameter of the optical path between the first (213, 403) and the second pump radiation reflecting element (202, 411) and/or the wavelength of the pump radiation beam such that the intensity of the pump radiation (214) reflected from the second optical cavity (225, 405) is minimized.

FIG. 1
(prior art)

FIG. 2a

FIG. 2b

FIG. 3

FIG. 4a

FIG. 4b

Europäisches
Patentamt

European
Patent Office

Office européen
des brevets

**EUROPEAN SEARCH REPORT**

Application Number

EP 09 01 4575

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | US 2001/043636 A1 (BEWLEY WILLIAM W [US] ET AL) 22 November 2001 (2001-11-22)<br>* paragraph [0041] * | 1-5,<br>11-13<br>15,16<br>6-10 | INV.<br>H01S3/08<br>H01S3/094<br>H01S5/04<br>H01S5/0687 |
| Y | WO 02/47223 A1 (UNIV SOUTHAMPTON [GB]; GARNACHE CREUILLOT ARNAUD [GB]) 13 June 2002 (2002-06-13)<br>* page 10, line 9 - page 11, line 22; figures 1,2 * | 1-16 | H01S5/14<br>H01S5/183<br>H01S3/13 |
| Y | US 2008/069156 A1 (KASAMATSU TADASHI [JP]) 20 March 2008 (2008-03-20)<br>* paragraph [0062]; figure 1 * | 1-16 | |
| A | DE 10 2006 002879 A1 (FRAUNHOFER GES FORSCHUNG [DE]) 2 August 2007 (2007-08-02)<br>* paragraph [0004]; figures 1,2 * | 1-16 | |
| A | EP 1 146 325 A2 (AGILENT TECHNOLOGIES INC [US]) 17 October 2001 (2001-10-17)<br>* paragraph [0011]; claim 1; figure 4 * | 8,9 | TECHNICAL FIELDS SEARCHED (IPC)<br><br>H01S |

The present search report has been drawn up for all claims

| Place of search | Date of completion of the search | Examiner |
|---|---|---|
| The Hague | 6 May 2010 | Claessen, Michiel |

EPO FORM 1503 03.82 (P04C01)

## ANNEX TO THE EUROPEAN SEARCH REPORT
## ON EUROPEAN PATENT APPLICATION NO.

EP 09 01 4575

This annex lists the patent family members relating to the patent documents cited in the above-mentioned European search report.
The members are as contained in the European Patent Office EDP file on
The European Patent Office is in no way liable for these particulars which are merely given for the purpose of information.

06-05-2010

| Patent document cited in search report | Publication date | Patent family member(s) | | Publication date |
|---|---|---|---|---|
| US 2001043636    A1 | 22-11-2001 | NONE | | |
| WO 0247223    A1 | 13-06-2002 | AU<br>GB | 2089702  A<br>2369929  A | 18-06-2002<br>12-06-2002 |
| US 2008069156    A1 | 20-03-2008 | JP | 2008034459  A | 14-02-2008 |
| DE 102006002879 A1 | 02-08-2007 | WO | 2007087959  A1 | 09-08-2007 |
| EP 1146325    A2 | 17-10-2001 | JP<br>US | 2002006238  A<br>6538748  B1 | 09-01-2002<br>25-03-2003 |

EPO FORM P0459

For more details about this annex : see Official Journal of the European Patent Office, No. 12/82